# DEMANDE DE BREVET EUROPEEN

(11) **EP 1 324 378 A1**
(43) Date de publication de la demande: **02.07.2003**
(21) Numéro de dépôt: 02102892.3
(22) Date de dépôt: 26.12.2002
(51) Int. Cl.: H01L 21/316, C23C 16/02

(54) **Structure multicouche, utilisée notamment en tant que matériau de forte permittivité relative**

(30) Priorité: 31.12.2001 FR 0117069; 11.02.2002 FR 0201618; 27.02.2002 FR 0202461; 20.03.2002 FR 0203442; 20.03.2002 FR 0203445; 20.03.2002 FR 0203444; 17.04.2002 FR 0204782; 30.04.2002 FR 0205465
(71) Demandeur: Memscap, 38190 Bernin (FR)
(72) Inventeur: Girardie, Lionel, 38320, EYBENS (FR)
(74) Mandataire: Palix, Stéphane

(57) **Abrégé**

Structure multicouche, utilisée notamment en tant que matériau de forte permittivité relative, **caractérisée** en ce qu'elle comporte une pluralité de couches distinctes, chacune d'une épaisseur inférieure à 500 Å, et dont certaines sont réalisée à base d'aluminium, d'hafhium et d'oxygène, et notamment à partir de dioxyde d'hafnium (HfO₂) et d'alumine (Al₂O₃). En pratique, les couches de dioxyde d'hafnium et d'alumine forment des alliages de formule HfₓAl_{y}O_{z}. Avantageusement, la stoechiométrie des alliages Hf_{X}Al_{y}O_{z} varie d'une couche à l'autre.

## Description

### Domaine technique

L'invention se rattache au domaine de la microélectronique. Elle vise plus précisément une structure multicouche, qui peut être utilisée notamment en tant que matériau de forte permittivité relative. Un tel matériau peut notamment être utilisé pour former la couche isolante d'un condensateur. Un tel condensateur peut notamment être utilisé en tant que capacité de découplage, ou bien encore capacité de filtrage intégrée dans des circuits radiofréquence ou analogues.

Ce type de matériau isolant peut également être utilisé pour être inclus dans des structures capacitives telles que celles formant les cellules de mémoires embarquées (ou embedded DRAM). De telles cellules peuvent être réalisées au sein même d'un circuit intégré.

L'invention permet également de réaliser des couches d'oxyde de grille (ou *gate stack*) que l'on retrouve dans les transistors de structure particulière, également connus sous le nom de structure de grille.

### Techniques antérieures

De façon générale, l'un des objectifs généralement recherché pour réaliser des structures capacitives, qu'il s'agisse de condensateurs ou de cellules de mémoire, est d'augmenter la capacitance de la structure, c'est-à-dire la valeur de la capacité par unité de surface, de manière à réduire au maximum la taille des composants.

Cette recherche d'une plus forte capacitance se fait notamment par l'utilisation de matériaux diélectriques présentant une permittivité relative aussi forte que possible.

La valeur de la capacité est également fonction inverse de la distance séparant les deux électrodes de la structure. C'est pourquoi il est généralement recherché de réduire l'épaisseur de la couche du matériau diélectrique séparant les deux électrodes d'une structure capacitive.

La réduction de cette épaisseur pose toutefois certains problèmes physiques en fonction des matériaux utilisés. En effet, lorsque les couches de matériaux diélectriques sont de très faible épaisseur, on peut voir apparaître certains phénomènes d'effets tunnel qui modifient le comportement de la structure capacitive en en dégradant les propriétés.

Par ailleurs, lorsqu'une couche diélectrique est soumise à une tension de trop forte amplitude, des phénomènes de claquage électrique peuvent également apparaître. On peut donc définir pour chaque matériau un champ électrique maximal de claquage, au-delà duquel il ne peut être employé.

Certains matériaux sont par exemple limités à des tensions de l'ordre de quelques volts, alors que le besoin existe de condensateurs utilisés notamment pour les opérations de découplage, susceptibles de supporter des tensions supérieures à la dizaine de volts.

En outre, le taux de courant de fuite est également un paramètre qui peut être critique dans certaines applications. On pourra notamment citer les condensateurs fonctionnant à haute fréquence, pour lesquels il est important de conserver un comportement de la capacité sur une bande de fréquence la plus large possible. Le taux de courant de fuite est également critique pour les applications requérant une forte autonomie, lorsque les condensateurs sont notamment embarqués sur des appareils sans fil.

Or, le taux de courant de fuite dépend notamment de la structure cristalline du matériau diélectrique.

On a proposé dans le document FR 2 526 622, de réaliser des structures multicouche associant des couches élémentaires de dioxyde de titane (TiO₂) et d'alumine (Al₂O₃), afin d'obtenir des matériaux présentant une permittivité relative élevée.

Ce type de structure présente l'inconvénient que le dioxyde de titane (TiO₂) est un matériau présentant une faible densité et une permittivité dépendante de la phase cristalline, ce qui nécessite de le coupler avec un matériau ayant une phase amorphe, y compris jusqu'à une température de 800°C, et présentant également un champ de claquage élevé. C'est pourquoi, pour éviter une augmentation de courant de fuite, ce document propose la superposition de couches de TiO₂ et de Al₂O₃. Les performances électriques de ce matériau sont utilisées pour des application de TFT (transistor thin film) mais sont insuffisantes pour des applications de découplage par des cellules de capacités. En effet, pour certaines applications, les courants de fuite sont déterminants pour un fonctionnement en radio-fréquence (RF), et notamment pour les générations de dispositifs de technologie CMOS et BICMOS HBT utilisés dans les appareils de communications sans fils, et notamment les futurs générations de téléphones mobiles connus sous l'appellation d'UMTS. Pour cette dernière application, la norme sur le découplage est telle qu'elle impose des courants de fuite inférieurs à 10⁻⁹ A/cm², à des tensions d'alimentation de 5,5V, en ayant un champ de claquage supérieur à 6 MV/cm. Pour qu'un matériau diélectrique puisse être utilisé dans cette application, il doit posséder une énergie d'inter bande (ou band gap) supérieur à 5.5 eV. Or l'empilement de couches de TiO₂ et Al₂O₃ ne possède qu'une énergie d'inter bande de 4 eV , un champ de claquage voisin de 3,5 MV/cm et des courants de fuite proche de 10⁻⁶ A/cm². Il apparaît très nettement que le matériau décrit dans ce document, développé pour des applications de TFT, ne peut être réutilisé pour des applications de condensateur de découplage RF et de cellule de capacité intégrée dans les circuits intégrés de technologie CMOS et BICMOS HBT

L'un des objectifs de l'invention est de proposer un matériau qui puisse être utilisé au sein de structures capacitives diverses, qui combine à la fois une forte valeur de permittivité relative avec une bonne tenue à la tension et un faible niveau de courant de fuite.

### Exposé de l'invention

L'invention concerne donc une structure multicouche, qui peut être réalisée notamment en tant que matériau de forte permittivité relative.

Conformément à l'invention, cette structure se caractérise en ce qu'elle comporte une pluralité de couches distinctes, chacune d'une épaisseur inférieure à 500 Å, et dont certaines sont réalisées à base d'aluminium, d'hafnium et d'oxygène. Ces couches peuvent par exemple être réalisées à base de dioxyde d'hafnium (HfO₂) et d'alumine (Al₂O₃). Avantageusement en pratique, les couches composées d'hafnium et d'alumine forment des alliages de formule HfₓAl_{y}O_{z}. Avantageusement, la stoechiométrie des alliages HfₓAl_{y}O_{z} varie d'une couche à l'autre.

Autrement dit, le matériau obtenu conformément à l'invention se présente sous forme d'une alternance de films ayant des compositions et des stoechiométries différentes, pour des épaisseurs inférieures à quelques centaines d'Angströms, formant ainsi une structure nanolaminée. En pratique, l'épaisseur des couches peut être préférentiellement inférieure à 200 Å, ou bien encore à 100 Å, voire même à 50 Å.

On a constaté de façon surprenante que les alliages d'Hafnium, d'oxygène et d'alumine présentaient des propriétés qui s'apparentent aux propriétés les plus favorables de chacun des composants de l'alliage.

Ainsi, le dioxyde d'Hafnium est connu pour être un matériau de structure polycristalline. Cette structure cristalline conduit le dioxyde d'Hafnium à être le siège de courants de fuite relativement élevés, bien que ce matériau soit très peu sensible aux phénomènes d'avalanches

Les courants de fuite du dioxyde d'Hafnium sont toutefois limités en raison de sa composition atomique et de sa faible densité en lacunes d'oxygène. Le dioxyde d'Hafnium est également résistant à la diffusion d'impuretés et à l'intermixage aux interfaces, en raison notamment de sa forte densité, à savoir de 9,68 g/cm². Le mécanisme de ces courants de fuite est basé sur des effets tunnel.

Le dioxyde d'Hafnium est également connu pour sa permittivité relative plutôt élevée, et de l'ordre de 20, lorsque ce matériau est déposé par ALD (de l'anglais Atomic Layer Deposition) à une température inférieure à 350°C.

S'agissant de la tenue en tension, le dioxyde d'Hafnium possède une énergie d'interbande ou band gap de 5,68 eV, pour un champ de claquage de 4 MV/cm.

En ce qui concerne l'uniformité de la permittivité relative, le diagramme capacité-tension montre une hystérésis correspondant à une épaisseur équivalente en SiO₂ (ou EOT pour Equivalent Oxyde Thickness) de 1,8 nanomètres, pour une plage de tension de 10 millivolts. Cela signifie que pour une légère variation de tension appliquée au matériau, celui-ci ne présente pas exactement les mêmes propriétés de permittivité, ce qui peut introduire des défauts de comportement électrique de la capacité, notamment lorsqu'elle est soumise à des sauts de tension.

En ce qui concerne l'autre composant de l'alliage, à savoir l'alumine, celui-ci est connu pour posséder une structure cristalline amorphe, favorable aux faibles courants de fuite, qui suivent le mécanisme de Poole-Frenkel. L'alumine présente une permittivité relative de 8,4, valeur inférieure à celle du dioxyde d'Hafnium.

En revanche, l'alumine présente une énergie d'interbande de 8,7 eV, et un champ de claquage de 7 MV/cm, valeurs supérieures à celles du dioxyde d'Hafnium évoqué ci-avant.

Or, on a remarqué de façon surprenante, que les alliages HfₓAl_{y}O_{z} formés par ces deux matériaux, présentent des propriétés particulièrement intéressantes, notamment en ce qui concerne la permittivité relative, qui est de l'ordre de 12 à 14. La tenue en tension est également avantageuse, puisque le champ de claquage global est de l'ordre de 6 MV/cm.

Par ailleurs, les alliages formés à base de HfO₂ et Al₂O₃ permettent de stopper la croissance des grains de dioxyde d'Hafnium par les phases amorphes d'alumine. On obtient donc un résultat qui se caractérise par la réduction des courants de fuite, alors qu'a priori, les deux matériaux pris séparément n'ont pas de mécanisme commun en ce qui concerne les courants de fuite.

Les alliages HfₓAl_{y}O_{z} formés et déposés par ALD présentent des avantages par rapport à une structure nanolaminée composée de l'empilement de couches successives de HfO₂ et de Al₂O₃. Ces avantages sont intimement liés à la structure des grains de l'alliage, à sa densité, et à l'enthalpie de formation qui donnent des courants de fuite de l'ordre de 10⁻⁹ A/cm² à 5,5V. En outre, la permittivité relative est supérieure à celle de l'empilement de couches séparées de HfO₂ et d'Al₂O₃. L'énergie de transition d'électron (ou barrière) par rapport à un métal est supérieure à 3,4 eV. L'inter bande de l'alliage HfₓAl_{y}O_{z} est supérieure à 6,5 eV alors que la structure nano-laminée composée de couches de HfO₂ et de Al₂O₃ présente une énergie d'inter bande de 5,7 eV.

Par ailleurs, la forte cohésion des cristaux, et la faible densité de lacune d'oxygène conduisent à une bonne uniformité de la permittivité relative de l'alliage caractéristique, lorsque celui-ci est déposé par la technique "ALD", pour "Atomic Layer Deposition" ou "dépôt de couches atomiques". Les courants de fuite observés sont typiquement de l'ordre du nanoampère par cm² sous une tension de 5 volts.

Dans une forme de réalisation particulière, la structure multicouche de l'invention peut comporter des couches externes qui sont réalisées uniquement en alumine. En effet, dans ce cas, on a observé que l'alumine Al₂O₃ présente une haute valeur de champ de claquage, et une énergie interbande relativement élevée, en comparaison aux principaux métaux, et notamment au tungstène qui est couramment utilisé pour former des électrodes de structures capacitives. Le seuil de tension de transition entre l'alumine et le tungstène est de l'ordre de 3,4 volts, ce qui rend l'alumine particulièrement avantageuse dans l'interface avec des électrodes métalliques et notamment en tungstène.

### Exemples de réalisation

Les différentes structures nanolaminées décrites ci-après ont été réalisées en utilisant des techniques de dépôt ALD, en déposant les différents composants de l'alliage à une température comprise entre 320 et 350°C de manière simultanée

Grâce à cette technique, il est possible de maîtriser l'épaisseur de chacune des couches, et ainsi de garantir une bonne homogénéité de cette épaisseur sur toute la surface de la couche élémentaire, et donc d'éviter les sources de défectivité.

La technique de dépôt par ALD peut utiliser plusieurs sources de matériaux, à savoir des sources solides, liquides ou gazeuses, ce qui rend cette technique très souple et évolutive. Par ailleurs, elle utilise des précurseurs qui sont les vecteurs de la réaction chimique de surface et qui transportent la matière à déposer. Plus précisément, ce transport met en oeuvre un processus de chimie sorption des précurseurs sur la surface à recouvrir, en créant une réaction chimique avec échange de ligand entre les atomes en surface et les molécules des précurseurs.

Le principe de cette technique évite l'adsorption des précurseurs ou leur condensation, et donc leur décomposition. Des sites nucléiques sont continuellement créés jusqu'à la saturation de chaque phase de la réaction, entre lesquels une purge à l'aide de gaz inerte permet de renouveler le processus. L'uniformité du dépôt est assurée par le mécanisme de réaction et non pas par les réactants utilisés, comme c'est le cas dans les techniques de Chemical Vapor Deposition (CVD), puisque l'épaisseur des couches déposées par ALD dépend de chaque cycle de chimie sorption des précurseurs.

Pour cette technique, il sera préférentiellement utilisé comme précurseurs des chlorites et oxychlorures tels que HfCl₄ ou TMA et Ozone ou H₂O, des métallocènes, des acyles de métaux, des béta dikétonates, ou des alkoxydes.

Ainsi, dans un premier exemple de mode opératoire, on enchaîne les étapes suivantes:
- injection de TMA (triméthylaluminium) à une température de 350°C, pendant une durée T1 variable selon la quantité souhaitée d'Aluminium dans la couche;
- injection d'un oxydant, tel qu'ozone, eau ou peroxyde d'hydrogène, à une température comprise entre 250 et 350° C, pendant une durée 1,5*T1
- injection de HfCl₄, à une température de 280°C, pendant une durée T2 variable selon la quantité souhaitée d'Hafnium dans la couche;
- injection d'un oxydant, pendant une durée 2*T2

De la sorte, on réalise une couche de formule AlₓO_{z1}Hf_{y}O_{z2}, et l'on peut répéter ces opérations de manière itérative pour obtenir la structure nanolaminée souhaitée.

Dans un second exemple de mode opératoire, on enchaîne les étapes suivantes:
- injection d'un alkoxyde, en tant que précurseur incluant de l'aluminium, à une température comprise entre 250°C et 320°C;
- injection d'un précurseur incluant des radicaux alkyls et de l'hafnium;
- injection d'un oxydant, tel qu'ozone, eau ou peroxyde d'hydrogène;

De la sorte, on réalise une couche de formule AlₓO_{z1}Hf_{y}O_{z2}, et l'on peut répéter ces opérations de manière itérative pour obtenir la structure nanolaminée souhaitée. L'avantage de cet exemple de mode opératoire réside dans le fait que les injections s'effectuent toutes à la même température, voisine de 280°C. Les phénomènes de migrations entre couches élémentaires sont donc nettement plus limités que dans les cas où la température varie à chaque injection. Le nombre d'injections par couche élémentaire est également réduit, de sorte que l'on diminue la présence d'impuretés et la concentration en lacunes, et en cross-diffusion d'oxygène. Les précurseurs peuvent être du TDEAH, à base de ligand TDEA (pour "Tétrakis (diéthylamino)") pour les complexes d'Hafnium, qui est fabriqué par certaines sociétés comme Schumacher Inc.

Parmi les différents exemples réalisés, on notera :

| Exemple A | | |
|---|---|---|
| ***N° de la couche*** | ***Formule de la couche*** | ***Epaisseur de la couche*** |
| 1 | Al₂O₃ | 5 angstroms |
| 2 | Hf₂AlO_{5,5} | 15 angstroms |
| 3 | Hf₃Al₂O₉ | 20 angstroms |
| 4 | Hf₃AlO_{7,5} | 25 angstroms |
| 5 | Hf₅AlO_{11,5} | 25 angstroms |
| 6 | Hf₃Al₂O₉ | 15 angstroms |
| 7 | Al₂O₃ | 5 angstroms |

Cette structure nanolaminée présente une permittivité relative de l'ordre de 14,21 et présente un champ de claquage de 7.3 MV/cm et une énergie d'inter bande de 6,4 eV et une énergie de transition électronique par rapport au nitrure de tungstène (WN) de 4,1 eV.

| Exemple B | | |
|---|---|---|
| ***N° de la couche*** | ***Formule de la couche*** | ***Epaisseur de la couche*** |
| 1 | Al₂O₃ | 5 angstroms |
| 2 | Hf₂Al_{7,5} | 15 angstroms |
| 3 | HfAl₈O₁₄ | 20 angstroms |
| 4 | Hf₅AlO_{11,5} | 25 angstroms |
| 5 | HfAl₆O₁₁ | 15 angstroms |
| 6 | Hf₃Al₂O₉ | 15 angstroms |
| 7 | Al₂O₃ | 5 angstroms |

Cette structure nanolaminee présente une permittivité relative de l'ordre de 12,23, et présente un champ de claquage de 6.8 MV/cm.

| Exemple C | | |
|---|---|---|
| ***N° de la couche*** | ***Formule de la couche*** | ***Epaisseur de la couche*** |
| 1 | HfAl₈O₁₄ | 10 angstroms |
| 2 | Hf₃AlO_{7,5} | 20 angstroms |
| 3 | HfAl₆O₁₁ | 10 angstroms |
| 4 | Hf₅AlO_{11,5} | 25 angstroms |
| 5 | HfAl₆O₁₁ | 10 angstroms |
| 6 | Hf₃Al₂O₉ | 20 angstroms |
| 7 | HfAl₈O₁₄ | 10 angstroms |

Cette structure nanolaminée présente une permittivité relative de l'ordre de 12,91.

| Exemple D | | |
|---|---|---|
| ***N° de la couche*** | ***Formule de la couche*** | ***Epaisseur de la couche*** |
| 1 | HfAl₉O₁₄ | 15 angstroms |
| 2 | Hf₃AlO_{7,5} | 20 angstroms |
| 3 | HfAl₆O₁₁ | 10 angstroms |
| 4 | Hf₅AlO_{11,5} | 25 angstroms |
| 5 | HfAl₆O_{11,5} | 10 angstroms |
| 6 | Hf₃Al₂O₉ | 15 angstroms |
| 7 | HfAl₈O₁₄ | 15 angstroms |

Cette structure nanolaminée présente une permittivité relative de l'ordre de 12,48.

| Exemple E | | |
|---|---|---|
| ***N° de la couche*** | ***Formule de la couche*** | ***Epaisseur de la couche*** |
| 1 | HfAl₈O₁₄ | 10 angstroms |
| 2 | Hf₃AlO_{7,5} | 25 angstroms |
| 3 | Hf₂AlO_{5,5} | 13 angstroms |
| 4 | Hf₃AlO_{11,5} | 30 angstroms |
| 5 | Hf₃Al₂O₉ | 13 angstroms |
| 6 | Hf₅AlO_{11,5} | 30 angstroms |
| 7 | HfAl₆O₁₁ | 11 angstroms |

Cette structure nanolaminée présente une permittivité relative de l'ordre de 14,46, et présente un champ de claquage de 7 MV/cm et une énergie d'inter bande de 6,3 eV et une énergie de transition électronique par rapport au nitrure de tungstène (WN) de 3,9 eV.

Bien entendu, les valeurs stoechiométriques données à ces différents exemples ne limitent pas la portée de l'invention, mais cette dernière couvre également de nombreuses autres variantes dès lors qu'elles respectent le principe de l'invention, à savoir une variation de la stoechiométrie entre les différents composants de l'alliage d'une couche à l'autre.

## Revendications

1. Structure multicouche, utilisée notamment en tant que matériau de forte permittivité relative, **caractérisée en ce qu'**elle comporte une pluralité de couches distinctes, chacune d'une épaisseur inférieure à 500 Å, et dont certaines sont réalisées à base d'aluminium, d'hafnium et d'oxygène.

2. Structure multicouche selon la revendication 1, **caractérisée en ce que** certaines des couches sont réalisées à base de dioxyde d'hafnium (HfO₂) et d'alumine (Al₂O₃).

3. Structure multicouche selon la revendication 1, **caractérisée en ce que** les couches à base de dioxyde d'hafnium (HfO₂) et d'alumine (Al₂O₃) sont formées d'alliages de formules HfₓAl_{y}O_{z}.

4. Structure multicouche selon la revendication 3, **caractérisée en ce que** les stoechiométries des alliages de formule HfₓAl_{y}O_{z} varient d'une couche à l'autre.

5. Structure multicouche selon la revendication 1, **caractérisée en ce que** l'épaisseur de chaque couche est comprise entre 1 et 200 Å, préférentiellement entre 1 et 100 Å, très préférentiellement entre 1 et 50 Å.

6. Structure multicouche selon la revendication 1, **caractérisée en ce qu'**elle comporte au moins cinq couches.

7. Structure multicouche selon la revendication 1, **caractérisée en ce que** au moins une des couches externes est réalisée en alumine (Al₂O₃)

8. Structure multicouche selon la revendication 1, **caractérisée en ce que** chaque couche est déposée par la technique de "dépôt de couches atomiques" (ALD).
